# EUROPEAN PATENT SPECIFICATION

(11) **EP 4 274 395 B1**
(45) Date of publication and mention of the grant of the patent: **21.01.2026**
(21) Application number: 22745217.4
(22) Date of filing: 25.01.2022
(51) Int. Cl.: H05K 7/20, F28D 15/02, F28F 9/26, F28D 21/00, F28F 3/12

(54) **HEAT DISSIPATION DEVICE, AND WIRELESS COMMUNICATION BASE STATION**
WÄRMEABLEITUNGSVORRICHTUNG UND BASISSTATION FÜR DRAHTLOSE KOMMUNIKATION
DISPOSITIF DE DISSIPATION DE CHALEUR, ET STATION DE BASE DE COMMUNICATION SANS FIL

(30) Priority: 28.01.2021 CN 202110119093
(43) Date of publication of application: 08.11.2023
(73) Proprietor: Huawei Technologies Co., Ltd., Shenzhen, Guangdong 518129 (CN)
(72) Inventor: WANG, Meng, Shenzhen, Guangdong 518129 (CN); HU, Weifeng, Shenzhen, Guangdong 518129 (CN); LU, Huawen, Shenzhen, Guangdong 518129 (CN)
(74) Representative: MERH-IP Matias Erny Reichl Hoffmann Patentanwälte PartG mbB
(86) International application number: PCT/CN2022/073693
(87) International publication number: WO 2022/161342

(56) References cited:
- EP-A1- 4 174 427
- CN-A- 106 686 958
- CN-A- 106 885 485
- CN-A- 106 885 485
- CN-A- 111 256 505
- CN-A- 111 504 095
- CN-A- 113 916 027
- CN-U- 212 211 744
- CN-U- 212 211 744
- JP-A- 2007 115 917
- US-A1- 2002 075 650
- US-A1- 2010 139 888
- US-A1- 2013 340 978

## Description

### CROSS-REFERENCE TO RELATED APPLICATIONS

### TECHNICAL FIELD

This application relates to the field of terminal technologies, and in particular, to a heat dissipation apparatus, a heat dissipation apparatus preparation method, and a wireless communication base station.

### BACKGROUND

With gradual development of a communication system from 2G and 3G to 4G and 5G, a base station device is increasingly developing towards large capacity, high power, and high integration. Heat generated by a base station in a working process also continuously increases, and an ambient temperature is one of important factors that affect performance and reliability of the base station. Currently, the base station mainly dissipates heat through natural wind. However, a natural wind heat dissipation manner cannot meet heat dissipation requirements of the existing base station.

EP4174427A1 discloses a heat sink and communication device that includes base board and a rib board. The base board has a cavity filled with a liquid working medium that turns into vapor when heated. This vapor enters chambers in the rib board, which has partition board dividing it into multiple chambers. The rib board cools the vapor back into liquid by exchanging heat with an external medium. The liquid then flows back to the base board, enabling two-phase heat dissipation.

CN106885485A discloses a pulsed hot junction variable cross-section heat pipe radiator that includes a pulsating cold end and multiple hot junctions. The cold end has multiple pulsation passages within a radiating plate body. The hot junction is a hollow cavity filled with a working medium and capillary wick. Each cold end interface on the hot junction's upper cover plate is connected to a pulsation cold end, linking the pulsation passages to the hollow cavity.

CN212211744 discloses a radiator comprising a heat dissipation substrate and heat dissipation fin groups on its surface. Heating components are inside the substrate, while the fins are on the outer surface, arranged in two opposite, staggered groups forming a vertical air channel between them. Each group has multiple inclined fins, creating an open V-shaped structure filled with refrigerant working media.

US2013/340978 discloses a two-phase heat exchanger for cooling electronic or electric components includes an evaporator and a condenser. The evaporator transfers heat from the components to a working fluid. The condenser, featuring a roll-bonded panel, has a first channel with a first and second connection port. The evaporator has a second channel with first and second connection openings. The first connection port of the condenser connects to a first connection opening of the evaporator, and the second connection port connects to a second connection opening. The working fluid circulates from the evaporator's second channel to the condenser's first channel, conveying heat by convection from the evaporator to the condenser.

Therefore, a heat dissipation apparatus is urgently required to dissipate heat for the base station.

### SUMMARY

The present invention provides a heat dissipation apparatus having the features of claim 1. Embodiments are defined in the dependent claims.

According to a first example that is not encompassed by the claims but useful for understanding the invention, this application provides a heat dissipation apparatus, including an evaporator and a plurality of ribbed plates connected to the evaporator, where the evaporator has a first cavity, and the first cavity is configured to accommodate a working medium for vapor-liquid two-phase conversion; and the ribbed plate includes a first side plate and a second side plate, where a second cavity is formed between the first side plate and the second side plate, a side that is of the first side plate and that faces the second side plate has a plurality of first protruding parts, a side that is of the second side plate and that faces the first side plate has a plurality of second protruding parts, and each first protruding part is fixedly connected to one corresponding second protruding part, so that the second cavity between the first side plate and the second side plate is divided into channels that are connected to the first cavity. When heat sources provide heat for the evaporator, a liquid phase working medium located in the first cavity is heated and vaporizes, and a vaporized working medium enters the second cavity. Because an outer surface of the ribbed plate may perform convection and radiation heat dissipation with external air, the working medium entering the second cavity liquefies, and a liquefied working medium flows back to the cavity. In this process, the working medium converts the heat generated by the heat sources through two processes: vaporization and liquefaction, and the heat generated by the heat sources is dissipated quickly, so that the heat sources can work continuously and stably. In addition, because the working medium entering the channel vaporizes, pressure borne by the ribbed plate that forms the channel is increased. Therefore, the heat dissipation apparatus needs to have sufficient strength. In this application, the first protruding part and the second protruding part are fixedly connected, so that strength of the ribbed plate can be improved, and working stability of the ribbed plate can be ensured. In addition, this structure is easy to be implemented by using some existing processes, so that processing costs are reduced.

In an example that is not encompassed by the claims but useful for understanding the invention , to reduce costs of the heat dissipation apparatus, the ribbed plate in the heat dissipation apparatus may be prepared by using a hot-rolling blow process or a stamping and brazing process. When the ribbed plate is implemented by using these processes, processing costs can be reduced.

It should be noted that, when the plurality of ribbed plates are specifically mounted on the evaporator, a first interface may be provided on the evaporator, the first interface is connected to the first cavity, a second interface is provided on the ribbed plate, and the second interface is connected to the channel. The first interface is connected to the second interface, and the ribbed plate may be mounted on the evaporator.

In some possible examples that are not encompassed by the claims but useful for understanding the invention , the evaporator may include a third side plate and a fourth side plate, and edges of the third side plate and the fourth side plate are sealed and bonded, so that the first cavity is formed between the third side plate and the fourth side plate, and the first interface is provided on the fourth side plate.

It should be noted that when the evaporator and the plurality of ribbed plates are specifically disposed, a height of the first cavity in the evaporator may be lower than a height of the second cavity in the ribbed plate. To be specific, in an actual application, the liquid phase working medium may be located in the first cavity, and the second cavity is configured to provide space for a gas phase for the working medium. Therefore, to prevent the liquid phase working medium from completely filling the second cavity, a highest point of the second cavity needs to be higher than a highest point of the first cavity. Alternatively, it may also be understood that a liquid surface height of the liquid phase working medium is lower than a highest point of the second cavity.

In addition, during specific implementation, a channel structure may be further formed in the second cavity. When the working medium in the first cavity is heated by the heat from the heat source, the liquid phase working medium vaporizes, and the vaporized working medium may enter the channel. Therefore, a flow rate of the working medium may be increased to some extent, and this helps improve a heat transfer effect between the working medium and the ribbed plate.

When the channel is provided, the first side plate is used as an example, and the first protruding part may be formed by squeezing a part of the first side plate towards one side of the second side plate. To be specific, a concave part is formed on one side that is of the first side plate and that is away from the second side plate, where a contour of the concave part corresponds to a contour of the first protruding part.

In the fourth side plate, a forming manner of the second protruding part may also be the same as or similar to that of the first protruding part, and details are not described herein.

Because a height of the channel is higher than the height of the first cavity, the liquefied working medium flows back to the first cavity under an action of gravity, and covers a part of the heat sources again. In this cycle manner, a stable working state is formed between the evaporator and the ribbed plate.

In some possible examples that are not encompassed by the claims but useful for understanding the invention , there may be a plurality of specific forms of the channel. For example, the channel is one of, or a combination of several of, a straight-line pipeline, a U-shaped pipeline, or a grid-shaped pipeline. The grid-shaped pipeline includes at least one of a right-angle grid-shaped pipeline, a diamond grid-shaped pipeline, a triangular grid-shaped pipeline, a circular grid-shaped pipeline, and a cellular grid-shaped pipeline.

In some possible examples that are not encompassed by the claims but useful for understanding the invention , when the ribbed plates are specifically connected to the evaporator, the second interface is provided on each ribbed plate. In this case, one first interface may be provided on the evaporator. The first interface extends along a height direction, and the one first interface corresponds to a plurality of second interfaces, so that the evaporator and the ribbed plates are connected.

In some possible examples that are not encompassed by the claims but useful for understanding the invention , when the ribbed plates are specifically connected to the evaporator, a quantity of first interfaces provided on the evaporator is the same as a quantity of ribbed plates. In this case, one first interface may be connected to one ribbed plate, and a quantity of second interfaces provided on each ribbed plate may be one or more. When the quantity of second interfaces provided on each ribbed plate is one, in a manufacturing process of the ribbed plate, only one second interface needs to be formed to be connected to one first interface on the fourth side plate, so that complexity of the ribbed plate can be reduced in the manufacturing process.

In some possible examples that are not encompassed by the claims but useful for understanding the invention , when the ribbed plates are specifically connected to the evaporator, and there are a plurality of first interfaces provided on the evaporator, the plurality of first interfaces are divided into a plurality of groups, each group of the first interfaces corresponds to one ribbed plate, and a quantity of second interfaces provided on each ribbed plate is the same as a quantity of first interfaces in each group, so that after the ribbed plates are connected to the evaporator, all the first interfaces on the evaporator are connected to the ribbed plates. When the heat sources work, the working medium in the first cavity is heated and starts to vaporize, and the vaporized working medium enters the channel through a part, in the plurality of second interfaces, that is not passed by the working medium, or the vaporized working medium directly vaporizes in the plurality of second interfaces and enters the channel.

In a first possible example that is not encompassed by the claims but useful for understanding the invention , when the ribbed plates are specifically connected to the evaporator, and the second interface provided on the ribbed plate may alternatively be a protruding tubular structure, the first interface located on the fourth side plate may be a round hole that cooperates with the tubular structure.

In the foregoing example that is not encompassed by the claims but useful for understanding the invention , the ribbed plates are inserted into the evaporator, the plurality of ribbed plates are disposed in an included angle (0-90°) with the evaporator in a height direction, and the plurality of ribbed plates are disposed in parallel. In this disposition manner, the evaporator and the ribbed plates can perform heat conduction with low thermal resistance and uniform temperature, to make full use of a layout of the heat transfer ribbed plates on the evaporator, implement better convective heat transfer of an external air duct, reduce an impact of an upper and lower heat series connection of the ribbed plates, and improve condensation heat transfer of the working medium in the first cavity and the channel (the second cavity).

In addition, the plurality of ribbed plates may be distributed in the evaporator in a plurality of forms, for example: The plurality of ribbed plates may also form two groups of ribbed plates. In the two groups of ribbed plates, each group of ribbed plates includes a plurality of parallel ribbed plates, and the two groups of ribbed plates are disposed on the evaporator in a V-shape, or may be disposed on the evaporator in an inverted V-shape. In this case, the plurality of first interfaces that are on the evaporator and that cooperate with the ribbed plates are also divided into two groups, and the two groups of first interfaces are in the V-shape or the inverted V-shape. Alternatively, the plurality of ribbed plates may form four groups of ribbed plates. In the four groups of ribbed plates, each group of ribbed plates includes a plurality of parallel ribbed plates, and the four groups of ribbed plates are disposed on the evaporator in a W-shape. In this case, the plurality of first interfaces that are on the evaporator and that cooperate with the ribbed plates are also divided into four groups, and the four groups of first interfaces are also provided in the W-shape. In this disposition manner, a heat transfer capability of the ribbed plate can be improved.

It should be noted that the plurality of ribbed plates may form three groups of ribbed plates, five groups of ribbed plates, six groups of ribbed plates, or the like. A quantity of groups of ribbed plates and a disposition manner need to be adjusted based on a specific use situation.

In some possible examples that are not encompassed by the claims but useful for understanding the invention , the ribbed plate may be rectangular, inverted L-shaped, or inverted Z-shaped. In addition, when the ribbed plate is in the inverted L-shape or inverted Z-shape, a height of a vertex of the ribbed plate may be higher than a height of the evaporator. In this way, when the heat sources work, the working medium in the first cavity is heated and starts to vaporize, the vaporized working medium passes through a channel that is higher than the evaporator, and the surface of the ribbed plate performs convection and radiation heat dissipation with the external air, so that the working medium passing through the channel in the ribbed plate condenses into liquid. After condensation, the liquid working medium may flow into a cavity in the evaporator along the channel under the action of gravity.

It should be noted that the ribbed plate may alternatively be in another shape, which is not enumerated herein.

In some possible examples that are not encompassed by the claims but useful for understanding the invention , a boss is disposed on a surface of the evaporator, the first interface is provided on the boss, and a part, of the second interface, that is inserted into the first interface is in a shape of a horn mouth, so that stability of a connection between the ribbed plates and the evaporator is improved.

In some possible examples that are not encompassed by the claims but useful for understanding the invention , the plurality of ribbed plates may be disposed in parallel, and the ribbed plates are disposed perpendicularly to the evaporator. The ribbed plates are disposed in parallel, so that an assembled heat dissipation apparatus is more beautiful.

According to a second example that is not encompassed by the claims but useful for understanding the invention , this application further provides a heat dissipation apparatus preparation method, and the method includes the following steps:
forming, in an evaporator, a first cavity configured to accommodate a working medium for vapor-liquid two-phase conversion;
forming a ribbed plate, where the ribbed plate includes a first side plate and a second side plate, a plurality of first protruding parts are formed on a side that is of the first side plate and that faces the second side plate, second protruding parts are formed on a side that is of the second side plate and that faces the first side plate, and each first protruding part is fixedly connected to one second protruding part, so that a second cavity in the ribbed plate is divided into channels; and
mounting the ribbed plate on the evaporator, where the channel is connected to the first cavity.

A specific method for forming the ribbed plate may include a plurality of forms, for example:
printing graphite powder on the first side plate and the second side plate based on a preset pipeline;
closely bonding the first side plate and the second side plate through high-temperature hot rolling;
blowing a reserved pipeline, so that a part, of the first side plate, that is printed with the graphite powder and a part, of the second side plate, that is printed with the graphite powder form, in a direction opposite to each other, concave parts, where a concave part on the first side plate and a concave part on the second side plate cooperate to form the channel, a part of the first side plate other than the part printed with the graphite powder forms the plurality of first protruding parts, and a part of the second side plate other than the part printed with the graphite powder forms the plurality of second protruding parts; and
cutting the first side plate and the second side plate that are bonded, to form the ribbed plate, and reserving, on the ribbed plate, a part that is connected to the evaporator; or
forming a first concave on a first surface of the first side plate by using a stamping process, and forming a second concave on a first surface of the second side plate by using the stamping process, so that an area, other than the first concave, on the first surface of the first side plate forms the plurality of first protruding parts, and an area, other than the second concave, on the first surface of the second side plate forms the plurality of second protruding parts;
welding the first protruding part of the first side plate and the second protruding part of the second side plate by using an aluminum brazing process, so that the first concave and the second concave cooperate to form the channel; and
cutting the first side plate and the second side plate that are bonded, to form the ribbed plate, and reserving, on the ribbed plate, a part that is connected to the evaporator.

It should be noted that the first side plate and the second side plate may be aluminum sheets, or may be replaced with another heat conducting material.

Because the ribbed plate is prepared by using the foregoing method, the ribbed plate may have high strength, and costs of the ribbed plate may be reduced, so that costs of the entire heat dissipation apparatus are reduced.

According to a third example that is not encompassed by the claims but useful for understanding the invention , this application provides a wireless communication base station, including a box, heat sources, and any one of the foregoing heat dissipation apparatuses. Specifically, the heat sources are disposed in the box, a mounting opening for mounting the heat dissipation apparatus is disposed on the box, and a part of the heat sources may be in contact with the heat dissipation apparatus located at the mounting opening. The heat dissipation apparatus can effectively conduct heat generated by the heat sources in contact with the heat dissipation apparatus and heat in the box, so that working reliability of the wireless communication base station is improved.

### BRIEF DESCRIPTION OF DRAWINGS

FIG. 1a is a schematic diagram of a partial structure of a box in a wireless communication base station according to an embodiment of this application;
FIG. 1b is a schematic diagram of a partial structure of a wireless communication base station according to an embodiment of this application;
FIG. 2a is a schematic diagram of a structure of a heat dissipation apparatus according to an embodiment of this application;
FIG. 2b is a schematic diagram of a structure of an evaporator in a heat dissipation apparatus according to an embodiment of this application;
FIG. 2c is a schematic diagram of a structure of a ribbed plate in a heat dissipation apparatus according to an embodiment of this application;
FIG. 3a is a first schematic diagram of a structure of a connection position between a ribbed plate and an evaporator in a heat dissipation apparatus according to an embodiment of this application;
FIG. 3b is a second schematic diagram of a structure of a connection position between a ribbed plate and an evaporator in a heat dissipation apparatus according to an embodiment of this application;
FIG. 3c is a third schematic diagram of a structure of a connection position between a ribbed plate and an evaporator in a heat dissipation apparatus according to an embodiment of this application;
FIG. 3d is a fourth schematic diagram of a structure of a connection position between a ribbed plate and an evaporator in a heat dissipation apparatus according to an embodiment of this application;
FIG. 4a is a first schematic diagram of distribution, of a ribbed plate that is in a heat dissipation apparatus, in an evaporator cavity according to an embodiment of this application;
FIG. 4b is a second schematic diagram of distribution, of a ribbed plate that is in a heat dissipation apparatus, in an evaporator cavity according to an embodiment of this application;
FIG. 4c is a third schematic diagram of distribution, of a ribbed plate that is in a heat dissipation apparatus, in an evaporator cavity according to an embodiment of this application;
FIG. 4d is a fourth schematic diagram of distribution, of a ribbed plate that is in a heat dissipation apparatus, in an evaporator cavity according to an embodiment of this application;
FIG. 5a is a first side view of a heat dissipation apparatus according to an embodiment of this application;
FIG. 5b is a second side view of a heat dissipation apparatus according to an embodiment of this application;
FIG. 5c is a third side view of a heat dissipation apparatus according to an embodiment of this application;
FIG. 5d is a fourth side view of a heat dissipation apparatus according to an embodiment of this application;
FIG. 5e is a fifth side view of a heat dissipation apparatus according to an embodiment of this application;
FIG. 5f is a sixth side view of a heat dissipation apparatus according to an embodiment of this application;
FIG. 6 is a schematic diagram of a structure of a connection between a ribbed plate and an evaporator in a heat dissipation apparatus according to an embodiment of this application; and
FIG. 7 is a flowchart of a heat dissipation apparatus preparation method according to an embodiment of this application.

### Reference numerals:

10: heat dissipation apparatus; 11: evaporator; 110: third side plate; 111: fourth side plate; 1110: first interface; 112: pipeline; 113: boss; 12: ribbed plate; 121: first side plate; 1210: first protruding part; 122: second side plate; 1220: second protruding part; 123: second interface; 20: box; 21: mounting opening; and 30: heat source.

### DESCRIPTION OF EMBODIMENTS

To make the objectives, technical solutions, and advantages of this application clearer, the following further describes this application in detail with reference to the accompanying drawings.

An existing wireless communication base station mainly includes components such as a transmitter and a power supply. The components such as the transmitter and the power supply generate a large amount of heat in a running process. To ensure normal running of the transmitter and the power supply, heat dissipation needs to be performed on the transmitter, the power supply, and another component in the wireless communication base station. Currently, a manner in which heat dissipation is performed on the component in the wireless communication base station is mainly a natural wind manner. With continuous improvement of product performance, pressure on an existing heat dissipation manner continuously increases, and the natural wind heat dissipation manner cannot meet heat dissipation requirements of the communication base station. In addition, a manner in which heat dissipation is performed on the component in the wireless communication base station may alternatively be that a heat pipe is embedded in a part of a side wall of the wireless communication base station, to improve a heat conductivity coefficient of the part, so that heat generated by a component that has high power and high heat consumption and that corresponds to the side wall is transferred to a position with a low temperature, and temperatures of a heat source and the wireless communication base station is reduced. However, the manner of embedding the heat pipe has high costs. When there are many components that have high power and high heat consumption, and an arrangement length is long, heat dissipation efficiency is low.

Therefore, this application provides a heat dissipation apparatus, so that a heat dissipation capability of the wireless communication base station is improved.

Terms used in the following embodiments are merely intended to describe specific embodiments, but not to limit this application. The terms "one", "a", "the", "the foregoing", "this", and "the one" of singular forms used in this specification and the appended claims of this application are also intended to include expressions such as "one or more", unless otherwise specified in the context clearly.

Reference to "an embodiment", "some embodiments", or the like described in this specification indicates that one or more embodiments of this application include a specific feature, structure, or characteristic described with reference to the embodiments. Therefore, statements such as "in an embodiment", "in some embodiments", "in some other embodiments", and "in other embodiments" that appear at different places in this specification do not necessarily refer to a same embodiment. Instead, the statements mean "one or more but not all of embodiments", unless otherwise specifically emphasized in another manner. The terms "include", "comprise", "have" and their variants mean "including but not limited to" unless specifically emphasized otherwise.

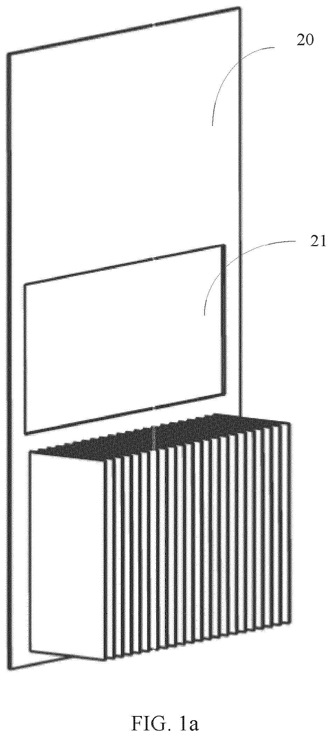

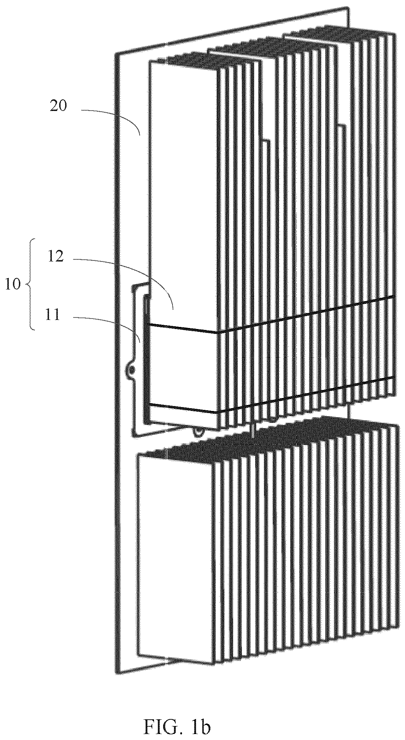

Refer to FIG. 1a and FIG. 1b. The wireless communication base station in this application may include a box 20, heat sources (not shown in the figure), and a heat dissipation apparatus 10. The heat sources are disposed in the box 20, the heat dissipation apparatus 10 is mounted in a mounting opening 21 of the box 20, and at least a part of the heat sources are thermally connected to an evaporator 11 on the heat dissipation apparatus. Specifically, the evaporator of the heat dissipation apparatus 10 is mounted at the mounting opening 21 of the box 20, and a ribbed plate 12 of the heat dissipation apparatus 10 is disposed on an outer side of the box 20. The heat sources may be a duplexer, a power amplifier, a transmitter, and a power module (not limited to the duplexer, the power amplifier, the transmitter, and the power module). The duplexer, the power amplifier, the transmitter, and the power module may be disposed in the box 20 and are thermally connected to a part, of the evaporator 11, that is located in the box 20. When the duplexer, the power amplifier, the transmitter, and the power module work, heat generated may be transferred to a first cavity in the evaporator 11. A working medium that is for vapor-liquid two-phase conversion and that is in the first cavity is heated and vaporizes. A vaporized working medium enters a channel of the ribbed plate 12 of the heat dissipation apparatus 10, and is dissipated to an external environment through natural convection and thermal radiation, so that the vaporized working medium passing through the ribbed plate 12 condenses and liquefies. In this manner, a heat dissipation capability of the wireless communication base station can be improved, and the wireless communication base station can work stably.

It should be noted that, when the heat dissipation apparatus is specifically mounted in the box, the heat dissipation apparatus may perform heat transfer with only the part of the heat sources.

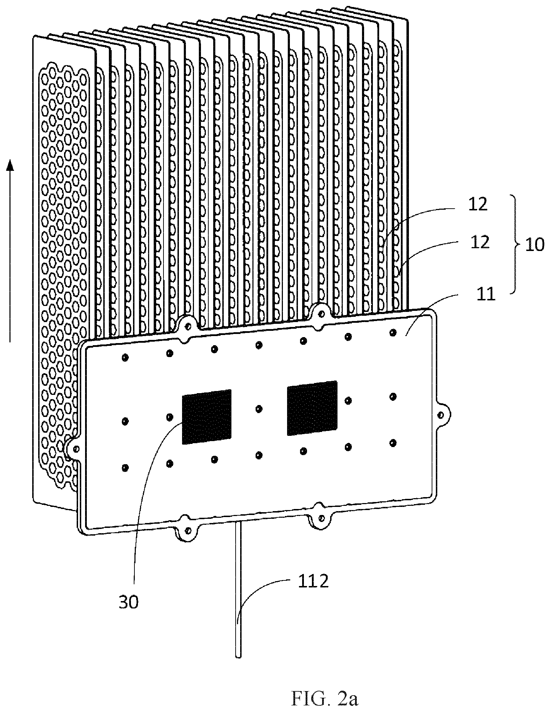

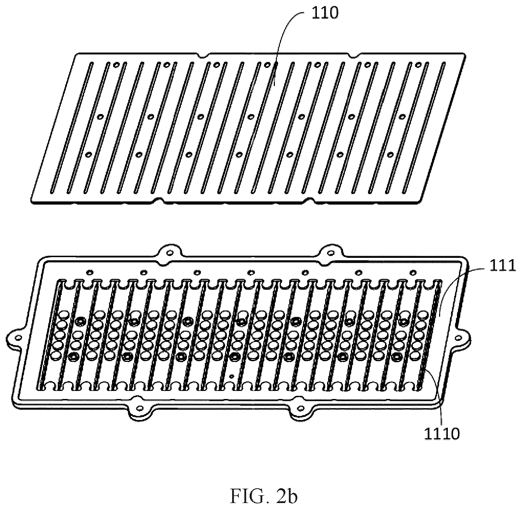

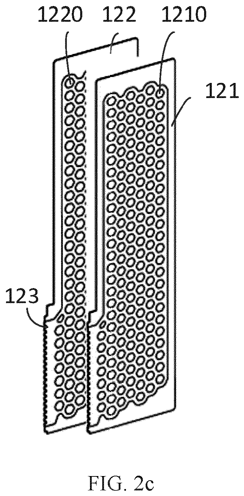

Refer to FIG. 2a to FIG. 2c. In an embodiment of this application, a heat dissipation apparatus 10 includes an evaporator 11 and a plurality of ribbed plates 12, and the evaporator 11 has a first cavity (not shown in the figure) configured to accommodate a liquid phase working medium. The ribbed plate 12 includes a first side plate 121 and a second side plate 122. A side that is of the first side plate 121 and that faces the second side plate 122 has a plurality of first protruding parts 1210, and a side that is of the second side plate 122 and that faces the first side plate 121 has a plurality of second protruding parts 1220. Each first protruding part 1210 is fixedly connected to one corresponding second protruding part 1220, so that a second cavity (not shown in the figure) between the first side plate 121 and the second side plate 122 is divided into channels that are connected to the first cavity. The liquid phase working medium in the first cavity is heated and vaporizes, and a vaporized working medium may enter the second cavity. Because an outer surface of the ribbed plate performs convection and radiation heat dissipation with external air, the vaporized working medium flowing in the second cavity liquefies, and heat is dissipated in processes of liquefaction and vaporization of the working medium. Specifically, the evaporator 11 is in contact with a heat source 30. In a process of vapor-liquid two-phase conversion of the working medium, heat generated by the heat source 30 that provides heat for the evaporator 11 can be effectively dissipated quickly, so that the heat source 30 can work stably. In addition, during working, because the working medium entering the channel vaporizes, the ribbed plate 12 that forms the channel bears large pressure. Therefore, the heat dissipation apparatus 10 needs to have sufficient strength. In this application, the first protruding part 1210 and the second protruding part 1220 in the ribbed plate 12 are provided, so that strength of the ribbed plate 12 can be increased, and working stability of the ribbed plate 12 can be ensured. In addition, this structure is easy to be implemented by using some existing processes, so that processing costs are reduced.

In an embodiment, to reduce costs of the heat dissipation apparatus 10, the ribbed plate 12 in the heat dissipation apparatus 10 may be prepared by using a hot-rolling blow process or a stamping and brazing process. When the ribbed plate 12 is implemented by using these processes, processing costs can be reduced.

According to the invention, when the evaporator 11 is specifically disposed, the evaporator 11 includes a third side plate 110 and a fourth side plate 111. Edges of the third side plate 110 and the fourth side plate 111 are sealed and bonded through brazing, so that the first cavity is formed between the third side plate 110 and the fourth side plate 111. The third side plate 110 is configured to be in thermal contact with the heat source 30. In addition, the evaporator 11 further includes a pipeline 112 configured to perform liquid injection and vacuumization on the first cavity, and a valve body may be disposed on the pipeline 112, to close the pipeline 112 after vacuumization and liquid injection on the first cavity are completed.

Specifically, when the plurality of ribbed plates 12 are mounted on the evaporator 11, a first interface 1110 (where the first interface 1110 may be provided on the fourth side plate 111) is provided on the evaporator 11, the first interface 1110 is connected to the first cavity, a second interface 123 is provided on the ribbed plate 12, and the second interface 123 is connected to the channel. The first interface 1110 is connected to the second interface 123, and the ribbed plate 12 may be mounted on the evaporator 11.

When the channel is specifically provided, the first protruding part 1210 may be formed by squeezing a part of the first side plate 121 towards one side of the second side plate 122, and the second protruding part 1220 may be formed by squeezing a part of the second side plate 122 towards one side of the first side plate 121. To be specific, a concave part is formed on one side that is of the first side plate 121 and that is away from the second side plate 122, and a concave part is formed on one side that is of the second side plate 122 and that is away from the first side plate 121. A contour of the concave part located on the first side plate 121 corresponds to a contour of the first protruding part 1210, and a contour of the concave part located on the second side plate 122 corresponds to a contour of the second protruding part 1220. In this manner, when the channel used for flow of a vapor phase working medium is formed, it may be further ensured that there are many connection points between the first side plate 121 and the second side plate 122, so that strength of the ribbed plate 12 is ensured.

According to an example, not covered by the present invention, there may be a plurality of forms of the channel. For example, the channel may be one of, or a combination of several of, a straight-line pipeline, a U-shaped pipeline, or a grid-shaped pipeline. The U-shaped pipeline or grid-shaped pipeline may be provided to increase a length of the channel, so that a speed at which the vaporized working medium performs convection and radiation heat dissipation with the external air is increased, and liquefaction of the vaporized working medium is accelerated.

It should be noted that the grid-shaped pipeline may specifically include at least one of a right-angle grid-shaped pipeline, a diamond grid-shaped pipeline, a triangular grid-shaped pipeline, a circular grid-shaped pipeline, and a cellular grid-shaped pipeline.

According to the invention, a direction of an arrow in FIG. 2a is a height direction, and a height of a vertex of the second cavity is greater than a height of the first cavity (a height of the ribbed plate 12 is greater than a height of the evaporator 11). To be specific, after the first cavity is filled with the liquid phase working medium, at least a part of space in the second cavity is not filled with the liquid phase working medium, so that a path for movement of the liquid phase working medium in the second cavity increases after the liquid phase working medium vaporizes, the speed at which the vaporized working medium performs convection and radiation heat dissipation with the external air is increased, the vaporized working medium liquefies quickly, and a liquefied working medium quickly converges with the liquid phase working medium under an action of gravity. In this arrangement manner, a heat dissipation speed can be effectively improved. In addition, when there are excessive working media in the first cavity, because a part of the second cavity is located above the first cavity, the vaporized working medium that enters the second cavity can still liquefy quickly, and applicability of the heat dissipation apparatus is improved.

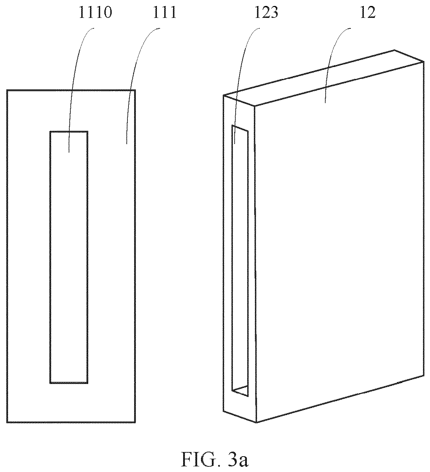

In the foregoing embodiment, the evaporator may be specifically connected to the ribbed plate in a plurality of manners. For example, in the plurality of ribbed plates, the second interface is provided on each ribbed plate. In this case, only one first interface may be specifically provided on the evaporator, and one interface is connected to a plurality of second interfaces on the plurality of second ribbed plates, so that the first cavity and the second cavity are connected. Alternatively, according to an example, which is not covered by the present invention, refer to FIG. 3a. A quantity of first interfaces 1110 (provided on the fourth side plate 111) provided on the evaporator is the same as a quantity of ribbed plates 12, that is, each first interface 1110 corresponds to one second interface 123. In this case, an extension direction of the first interface 110 is the same as the height direction. In this arrangement manner, in a manufacturing process of each ribbed plate 12, only one second interface 123 needs to be formed to be connected to one first interface 1110 on the fourth side plate 111, so that complexity of the ribbed plate 12 can be reduced in the manufacturing process. When the heat sources start to work, the working medium in the first cavity is heated and starts to vaporize, and the vaporized working medium enters the channel through a part, in the second interface 123, that is not passed by the working medium, or the vaporized working medium directly vaporizes in the second interface 123 and enters the channel (the second cavity).

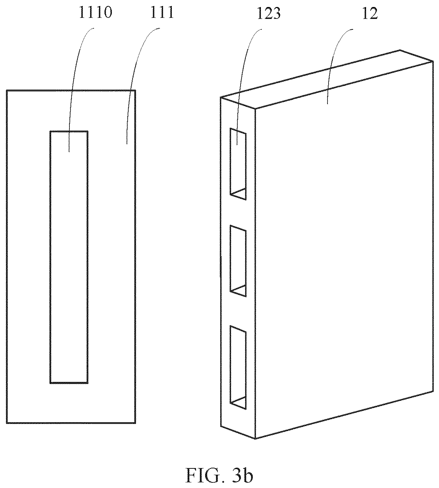

Refer to FIG. 3b. The evaporator is provided with a plurality of first interfaces 1110 (the first interface 1110 is provided on the fourth side plate 111), the plurality of first interfaces 1110 extend along the height direction, each first interface 1110 is connected to one ribbed plate 12, and each ribbed plate 12 is provided with a plurality of second interfaces 123, that is, one first interface 1110 corresponds to the plurality of second interfaces 123 provided on the one ribbed plate 12. When the heat sources work, the working medium in the first cavity is heated and starts to vaporize, and the vaporized working medium enters the channel through a part, in the plurality of second interface 123, that is not passed by the working medium, or the vaporized working medium directly vaporizes in the plurality of second interface 123 and enters the channel.

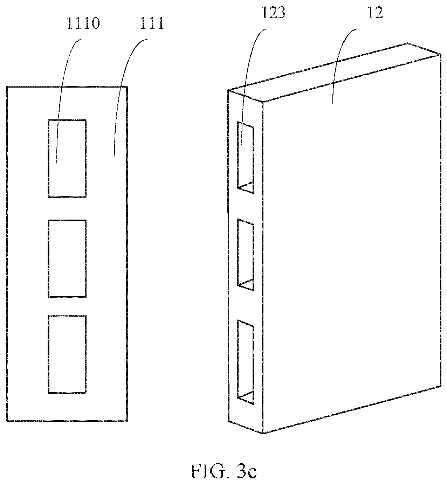

Refer to FIG. 3c. The evaporator is provided with a plurality of first interfaces 1110 (the first interface 1110 is provided on the fourth side plate 111), the plurality of first interfaces 1110 extend along the height direction, and the plurality of first interfaces 1110 correspond to one ribbed plate 12. In this case, a quantity of second interfaces 123 provided on each ribbed plate 12 is the same as a quantity of first interfaces 1110 that correspond to the second interfaces 123, that is, the plurality of first interfaces 1110 are provided in a one-to-one correspondence with a plurality of second interfaces 123 on the one ribbed plate 12. When the heat sources work, the working medium in the first cavity is heated and starts to vaporize, and the vaporized working medium enters the channel through a part, in the plurality of second interface 123, that is not passed by the working medium, or the vaporized working medium directly vaporizes in the plurality of second interface 123 and enters the channel.

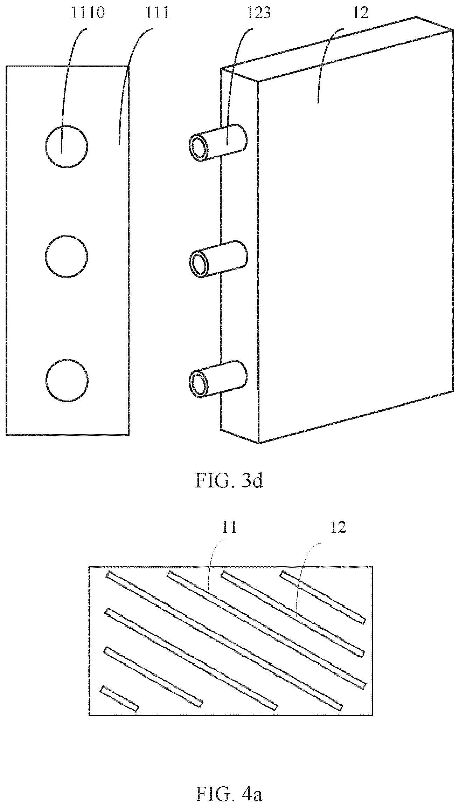

It should be noted that the first interface and the second interface are configured to connect the ribbed plate to the evaporator, and a specific form of the first interface and the second interface may alternatively be another structure. For example, refer to FIG. 3d. When the second interface 123 provided on the ribbed plate 12 may alternatively be a protruding tubular structure, the first interface 1110 located on the fourth side plate 111 may be a round hole that cooperates with the tubular structure. In addition, when the ribbed plate 12 is specifically disposed, the outer surface of the ribbed plate may also be set as a planar structure through improvement of a process.

In the foregoing embodiment, refer to FIG. 4a. The ribbed plate 12 may be disposed on the evaporator 11 in a plurality of manners. For example, the first interface on the second side plate of the evaporator 11 is provided in an included angle with the height direction (where the included angle between the first interface and the height direction is 0-90°). When there are a plurality of first interfaces, the plurality of first interfaces are provided in parallel. In this case, the ribbed plate 12 is inserted into the evaporator 11, the ribbed plate 12 is also disposed in an included angle with the height direction, and the plurality of ribbed plates 12 are disposed in parallel. In this disposition manner, the evaporator 11 and the ribbed plates 12 can perform heat conduction with low thermal resistance and uniform temperature, to make full use of a layout of the heat transfer ribbed plates 12 on the evaporator 11, implement better convective heat transfer of an external air duct, reduce an impact of an upper and lower heat series connection of the ribbed plates 12, and improve condensation heat transfer of the working medium in the first cavity and the channel (the second cavity).

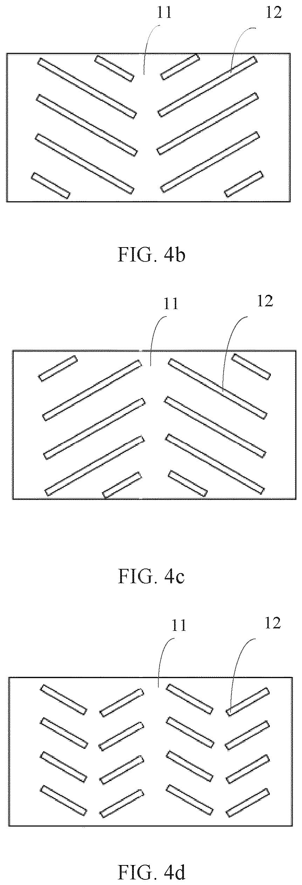

Refer to FIG. 4b and FIG. 4c. The plurality of ribbed plates 12 may also form two groups of ribbed plates. In the two groups of ribbed plates, each group of ribbed plates includes a plurality of parallel ribbed plates 12, and the two groups of ribbed plates 12 are disposed on the evaporator 11 in a V-shape, or may be disposed on the evaporator 11 in an inverted V-shape. In this case, the plurality of first interfaces that are on the evaporator 11 and that cooperate with the ribbed plates 12 are also divided into two groups, and the two groups of first interfaces are in the V-shape or the inverted V-shape. In this disposition manner, a heat transfer capability of the ribbed plate 12 can be improved.

Refer to FIG. 4d. The plurality of ribbed plates 12 may form four groups of ribbed plates. In the four groups of ribbed plates, each group of ribbed plates includes a plurality of parallel ribbed plates 12, and the four groups of ribbed plates are disposed on the evaporator 11 in a W-shape. In this case, the plurality of first interfaces that are on the evaporator 11 and that cooperate with the ribbed plates 12 are also divided into four groups, and the four groups of first interfaces are provided in the W-shape. In this disposition manner, a heat transfer capability of the ribbed plate 12 can be improved.

It should be noted that the plurality of ribbed plates 12 may form three groups of ribbed plates, five groups of ribbed plates, six groups of ribbed plates, or the like. A quantity of groups of ribbed plates 12 and a disposition manner need to be adjusted based on a specific use situation.

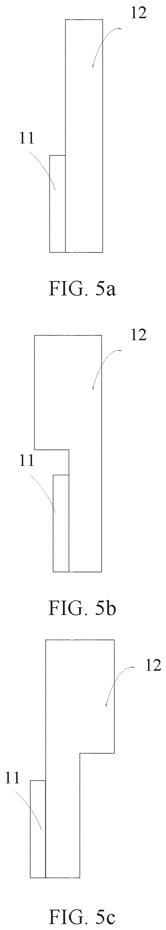

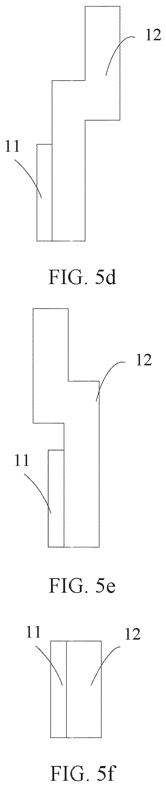

Refer to FIG. 5a to FIG. 5e. In some possible embodiments, a plurality of shapes of the ribbed plate 12 may be set. For example, the shape of the ribbed plate 12 may be an inverted L-shape, an inverted Z-shape, or a rectangle. Specifically, when the shape of the ribbed plate 12 is the inverted L-shape, in the height direction, the height of the vertex of the ribbed plate 12 (the second cavity) may be higher than the height of the evaporator 11, and one side of the ribbed plate 12 disposed in the inverted L-shape may extend right above the evaporator 11, or one side of the ribbed plate disposed in the inverted L-shape is higher than the height of the evaporator 11, and the side extends to a side away from the evaporator 11. When the ribbed plate 12 is in the inverted Z-shape, one side of the ribbed plate 12 disposed in the inverted Z-shape is located right above the evaporator 11, or a height of a side of the ribbed plate 12 disposed in the inverted Z-shape is higher than the evaporator 11, and the side extends in a vertical direction; and a side of the ribbed plate 12 does not overlap with the evaporator 11 during projection on a horizontal plane. When the ribbed plate 12 is rectangular, the ribbed plate 12 may be disposed in parallel with the evaporator 11. The vertex of the ribbed plate 12 (the second cavity) may be higher than the evaporator 11, that is, at least a part provided in the ribbed plate 12 is located above the first cavity. In this way, when the heat sources work, the working medium in the first cavity is heated and starts to vaporize, the vaporized working medium passes through a channel higher than the evaporator 11, and the surface of the ribbed plate 12 performs convection and radiation heat dissipation with the external air, so that the working medium passing through the channel in the ribbed plate 12 condenses into liquid. After condensation, the liquid working medium may flow into a cavity in the evaporator 11 along the channel under the action of gravity, so that a part, of the heat sources, that is in contact with the evaporator 11 is covered by the liquid working medium. In this cycle manner, a stable working state is formed between the evaporator 11 and the ribbed plate 12.

It should be noted that the ribbed plate may be in a specific shape in a plurality of forms, which are not enumerated herein. In addition, a top of the ribbed plate and a top of the evaporator may be at a same height. Refer to FIG. 5f. The height of the ribbed plate 12 is the same as the height of the evaporator 11. In this case, the working medium vaporizes under an action of the heat sources. Because the channel in the ribbed plate 12 is formed by bulging of the third side plate and/or the fourth side plate outward, contact space between the channel and an external environment is increased, and liquefaction of the vaporized working medium is accelerated.

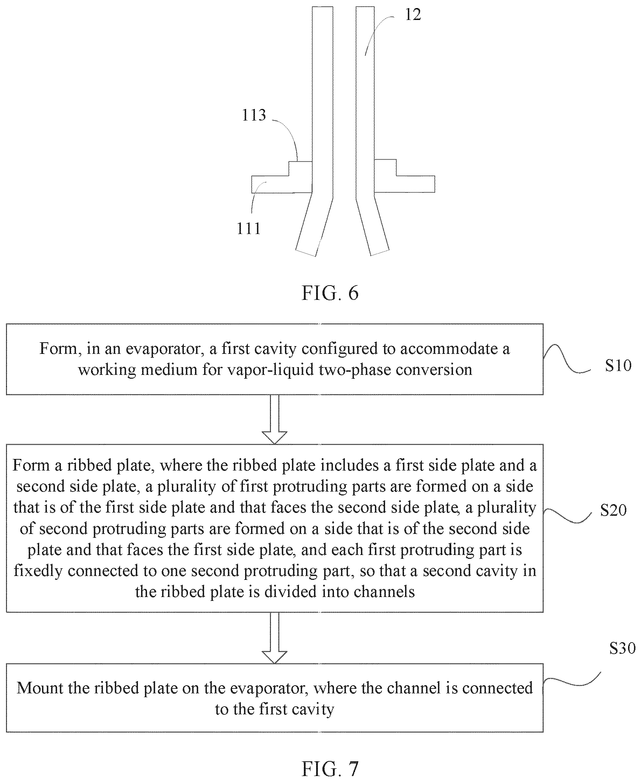

Refer to FIG. 6. In some possible embodiments, to improve reliability of inserting a ribbed plate 12 into an evaporator, a boss 113 may be disposed on a surface of the evaporator (a fourth side plate 111), and a first interface configured to cooperate with the ribbed plate 12 is formed on the boss 113, and a second interface configured to be inserted into a first cavity is in a shape of a horn mouth, so that a part, of the second interface, that is in the shape of the horn mouth can be in contact with an inner wall of the evaporator after the second interface is inserted into the second interface, and stability of a connection between an inserting part and the evaporator is improved.

It should be noted that, to make a connection between the evaporator and the ribbed plate 12 a sealed connection, the ribbed plate 12 is further welded with an outer wall surface formed by the boss 113 or an inner wall surface formed by the boss 113. When welded with the outer wall surface formed by the boss 113, the ribbed plate 12 further includes a welding part welded with the outer wall surface. When the ribbed plate 12 is welded with the inner wall surface of the boss 113, a part of the second interface is welded with the inner wall surface of the boss 113.

In the foregoing embodiment, to improve heat dissipation efficiency of a heat dissipation apparatus, an enhanced vaporization evaporation structure may be disposed on a side that is of the evaporator and that is close to a heat source. The evaporation structure may be specifically one of, or a combination of several of, a cylinder located on the side that is of the evaporator and that is close to the heat source, a groove formed on the side that is of the evaporator and that is close to the heat source, and a capillary liquid absorption core (silk mesh or burnt powder) disposed on the side that is of the evaporator and that is close to the heat source.

The foregoing heat dissipation apparatus is disposed in a heat consumption concentration area of an outdoor base station. In comparison with an outdoor base station using a conventional heat dissipation apparatus, in this solution, a local heat source temperature can be improved by more than 5°C after a test.

Refer to FIG. 7. This application further provides a heat dissipation apparatus preparation method, according to an example, which is not covered by the present invention, and the method includes following steps.

S10: Form, in an evaporator, a first cavity configured to accommodate a working medium for vapor-liquid two-phase conversion.

S20: Form a ribbed plate, where the ribbed plate includes a first side plate and a second side plate, a plurality of first protruding parts are formed on a side that is of the first side plate and that faces the second side plate, a plurality of second protruding parts are formed on a side that is of the second side plate and that faces the first side plate, and each first protruding part is fixedly connected to the second protruding part, so that a second cavity in the ribbed plate is divided into channels.

S30: Mount the ribbed plate on the evaporator, where the channel is connected to the first cavity.

Specifically, a method for forming the ribbed plate may include:
S21: Print graphite powder on the first side plate and the second side plate based on a preset pipeline.
S22: Closely bond the first side plate and the second side plate through high-temperature hot rolling.
S23: Blow a reserved pipeline, so that a part, of the first side plate, that is printed with the graphite powder and a part, of the second side plate, that is printed with the graphite powder form, in a direction opposite to each other, concave parts, where a concave part on the first side plate and a concave part on the second side plate cooperate to form the channel, a part of the first side plate other than the part printed with the graphite powder forms the plurality of first protruding parts, and a part of the second side plate other than the part printed with the graphite powder forms the plurality of second protruding parts.
S24: Cut the first side plate and the second side plate that are bonded, to form the ribbed plate, and reserve, on the ribbed plate, a part that is connected to the evaporator.

According to an example, which is not covered by the present invention, a method for forming the ribbed plate may alternatively include:
S201: Form a first concave on a first surface of the first side plate by using a stamping process, and forming a second concave on a first surface of the second side plate by using the stamping process, so that an area, other than the first concave, on the first surface of the first side plate forms the plurality of first protruding parts, and an area, other than the second concave, on the first surface of the second side plate forms the plurality of second protruding parts.
S202: Weld the first protruding part of the first side plate and the second protruding part of the second side plate by using an aluminum brazing process, so that the first concave and the second concave cooperate to form the channel.
S203: Cut the first side plate and the second side plate that are bonded, to form the ribbed plate, and reserve, on the ribbed plate, a part that is connected to the evaporator.

It should be noted that the first side plate and the second side plate may be aluminum sheets, or may be replaced with another heat conducting material.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A heat dissipation apparatus (10), comprising:
an evaporator (11), wherein the evaporator (11) has a first cavity, and the first cavity is configured to accommodate a working medium for vapor-liquid two-phase conversion, wherein the evaporator comprises a third side plate (110) and a fourth side plate (111), wherein edges of the third side plate (110) and the fourth side plate (111) are sealed and bonded, and the first cavity is formed between the third side plate (110) and the fourth side plate (111), and wherein the third side plate (110) is configured to be in contact with a heat source, and
a plurality of ribbed plates (12) connected to the evaporator (11), each of the plurality of ribbed plates comprising:
a first side plate (121) and a second side plate (122), creating a second cavity between the first side plate (121) and the second side plate (122), wherein a side that is of the first side plate (121) and that faces the second side plate (122) has a plurality of first protruding parts (1210), a side that is of the second side plate (122) and that faces the first side plate (121) has a plurality of second protruding parts (1220), and wherein each first protruding part (1210) is fixedly connected to a corresponding second protruding part (1220), so that the second cavity is divided into channels that are connected to the first cavity; and
a plurality of second interfaces (123) arranged along a height direction of the ribbed plate (12), each located at an edge of the ribbed plate (12) and connected to the second cavity, wherein a height of the second cavity in the height direction is greater than a height of the first cavity,
wherein for each of the ribbed plates (12), the evaporator (11) has at least one first interface (1110) connected to the plurality of second interfaces (123), wherein a quantity of the first interfaces (1110) is less than a quantity of the second interfaces (123), or
wherein for each of the ribbed plates (12), the evaporator (11) has a plurality of first interfaces (1110) connected to the plurality of second interface (123) in a one-to-one manner, wherein a quantity of the first interfaces (1110) is the same as a quantity of the second interfaces (123).

2. The heat dissipation apparatus (10) according to claim 1, wherein the plurality of ribbed plates (12) are formed by using a hot-rolling blow process; or the plurality of ribbed plates (12) are formed by using a stamping and brazing process.

3. The heat dissipation apparatus (10)according to claim 1, wherein a boss (113) is disposed on an outer surface of the fourth side plate (111), and a first interface (1110) is located on a top of the boss (113).

4. The heat dissipation apparatus (10) according to claim 1, wherein a part of the second interface (123) that is connected to the first interface (1110) is in a shape of a horn mouth.

5. The heat dissipation apparatus (10) according to claim 1, wherein the plurality of the ribbed plates (12) and the fourth side plate (111) are perpendicular to each other.

6. The heat dissipation apparatus (10) according to any one of claims 1 to 5, wherein the plurality of ribbed plates (12)are disposed in parallel with each other or disposed in an included angle, wherein the included angle is defined between the fourth side plate (111) of the evaporator (11) and each of the ribbed plates (12), wherein the included angle ranges from 0 degrees to 90 degrees.

7. The heat dissipation apparatus (10) according to any one of claims 1 to 6, wherein the plurality of ribbed plates (12) is rectangular, inverted L-shaped, or inverted Z-shaped.

8. A wireless communication base station, comprising: a box (20), heat sources (30), and the heat dissipation apparatus (10) according to any one of claims 1 to 7, wherein a mounting opening (21) for mounting the heat dissipation apparatus (10) is provided on the box (20), the heat sources (30) are disposed in the box (20), and at least a part of the heat sources (30) are thermally connected to the evaporator (11).

## Patentansprüche

1. Wärmeableitungseinrichtung (10), die umfasst:
einen Verdampfer (11), wobei der Verdampfer (11) einen ersten Hohlraum aufweist und der erste Hohlraum konfiguriert ist, um ein Arbeitsmedium für eine Dampf-Flüssigkeit-Zweiphasenumwandlung aufzunehmen, wobei der Verdampfer eine dritte Seitenplatte (110) und eine vierte Seitenplatte (111) umfasst, wobei Kanten der dritten Seitenplatte (110) und der vierten Seitenplatte (111) versiegelt und gebunden sind und der erste Hohlraum zwischen der dritten Seitenplatte (110) und der vierten Seitenplatte (111) ausgebildet ist, und wobei die dritte Seitenplatte (110) konfiguriert ist, um mit einer Wärmequelle in Kontakt zu stehen und
eine Vielzahl von Rippenplatten (12), die mit dem Verdampfer (11) verbunden sind,
wobei jede der Vielzahl von Rippenplatten umfasst:
eine erste Seitenplatte (121) und eine zweite Seitenplatte (122), die einen zweiten Hohlraum zwischen der ersten Seitenplatte (121) und der zweiten Seitenplatte (122) herstellen, wobei eine Seite, die zu der ersten Seitenplatte (121) gehört und die der zweiten Seitenplatte (122) zugewandt ist, eine Vielzahl von ersten vorstehenden Teilen (1210) aufweist, eine Seite, die zu der zweiten Seitenplatte (122) gehört und die der ersten Seitenplatte (121) zugewandt ist, eine Vielzahl von zweiten vorstehenden Teilen (1220) aufweist, und wobei jeder erste vorstehende Teil (1210) mit einem entsprechenden zweiten vorstehenden Teil (1220) fest verbunden ist, sodass der zweite Hohlraum in Kanäle, die mit dem ersten Hohlraum verbunden sind, unterteilt ist; und
eine Vielzahl von zweiten Schnittstellen (123), die entlang einer Höhenrichtung der Rippenplatte (12) angeordnet sind, die sich jeweils an einer Kante der Rippenplatte (12) befinden und mit dem zweiten Hohlraum verbunden sind, wobei eine Höhe des zweiten Hohlraums in der Höhenrichtung größer als eine Höhe des ersten Hohlraums ist, wobei, für jede der Rippenplatten (12), der Verdampfer (11) mindestens eine erste Schnittstelle (1110) aufweist, die mit der Vielzahl von zweiten Schnittstellen (123) verbunden ist, wobei eine Anzahl der ersten Schnittstellen (1110) geringer als eine Anzahl der zweiten Schnittstellen (123) ist, oder
wobei, für jede der Rippenplatten (12), der Verdampfer (11) eine Vielzahl von ersten Schnittstellen (1110) aufweist, die auf eine Eins-zu-Eins-Weise mit der Vielzahl von zweiten Schnittstellen (123) verbunden sind, wobei eine Anzahl der ersten Schnittstellen (1110) die gleich wie eine Anzahl der zweiten Schnittstellen (123) ist.

2. Wärmeableitungseinrichtung (10) nach Anspruch 1, wobei die Vielzahl von Rippenplatten (12) durch Verwenden eines Warmwalzblasprozesses ausgebildet wird; oder die Vielzahl von Rippenplatten (12) durch Verwenden eines Stanz- und Lötprozesses ausgebildet wird.

3. Wärmeableitungseinrichtung (10) nach Anspruch 1, wobei ein Vorsprung (113) auf einer äußeren Oberfläche der vierten Seitenplatte (111) angeordnet ist und sich eine erste Schnittstelle (1110) auf einer Oberseite des Vorsprungs (113) befindet.

4. Wärmeableitungseinrichtung (10) nach Anspruch 1, wobei ein Teil der zweiten Schnittstelle (123), der mit der ersten Schnittstelle (1110) verbunden ist, in einer Form einer Hornmündung vorliegt.

5. Wärmeableitungseinrichtung (10) nach Anspruch 1, wobei die Vielzahl der Rippenplatten (12) und die vierte Seitenplatte (111) senkrecht zueinander sind.

6. Wärmeableitungseinrichtung (10) nach einem der Ansprüche 1 bis 5, wobei die Vielzahl von Rippenplatten (12) parallel zueinander angeordnet sind oder in einem eingeschlossenen Winkel angeordnet sind, wobei der eingeschlossene Winkel zwischen der vierten Seitenplatte (111) des Verdampfers (11) und jeder der Rippenplatten (12) definiert ist, wobei der eingeschlossene Winkel in einem Bereich von 0 Grad bis 90 Grad liegt.

7. Wärmeableitungseinrichtung (10) nach einem der Ansprüche 1 bis 6, wobei die Vielzahl von Rippenplatten (12) rechteckig, umgekehrt L-förmig oder umgekehrt Z-förmig ist.

8. Drahtlose Kommunikationsbasisstation, die umfasst: eine Box (20), Wärmequellen (30) und die Wärmeableitungseinrichtung (10) nach einem der Ansprüche 1 bis 7, wobei eine Montageöffnung (21) zum Montieren der Wärmeableitungseinrichtung (10) an der Box (20) bereitgestellt ist, die Wärmequellen (30) in der Box (20) angeordnet sind und mindestens ein Teil der Wärmequellen (30) mit dem Verdampfer (11) thermisch verbunden ist.

## Revendications

1. Appareil de dissipation thermique (10), comprenant :
un évaporateur (11), dans lequel l'évaporateur (11) a une première cavité, et la première cavité est conçue pour accueillir un milieu de travail pour une conversion biphasique vapeur-liquide, dans lequel l'évaporateur comprend une troisième plaque latérale (110) et une quatrième plaque latérale (111), dans lequel des bords de la troisième plaque latérale (110) et de la quatrième plaque latérale (111) sont scellés et collés, et la première cavité est formée entre la troisième plaque latérale (110) et la quatrième plaque latérale (111), et dans lequel la troisième plaque latérale (110) est conçue pour être en contact avec une source de chaleur, et
une pluralité de plaques nervurées (12) reliées à l'évaporateur (11), chacune des plaques nervurées comprenant :
une première plaque latérale (121) et une deuxième plaque latérale (122), créant une seconde cavité entre la première plaque latérale (121) et la deuxième plaque latérale (122), dans lequel un côté de la première plaque latérale (121) et qui fait face à la deuxième plaque latérale (122) présente une pluralité de premières parties saillantes (1210), un côté de la deuxième plaque latérale (122) qui fait face à la première plaque latérale (121) présente une pluralité de secondes parties saillantes (1220), et dans lequel chaque première partie saillante (1210) est reliée de manière fixe à une seconde partie saillante correspondante (1220), de sorte que la seconde cavité est divisée en canaux qui sont reliés à la première cavité ; et
une pluralité de secondes interfaces (123) disposées le long d'une direction de hauteur de la plaque nervurée (12), chacune située sur un bord de la plaque nervurée (12) et reliée à la seconde cavité, dans lequel une hauteur de la seconde cavité dans la direction de hauteur est plus grande qu'une hauteur de la première cavité,
dans lequel, pour chacune des plaques nervurées (12), l'évaporateur (11) possède au moins une première interface (1110) reliée à la pluralité de secondes interfaces (123), dans lequel une quantité de premières interfaces (1110) est inférieure à une quantité des secondes interfaces (123), ou
dans lequel, pour chacune des plaques nervurées (12), l'évaporateur (11) a une pluralité de premières interfaces (1110) reliées à la pluralité de secondes interfaces (123) de manière univoque, dans lequel une quantité de premières interfaces (1110) est la même qu'une quantité des secondes interfaces (123).

2. Appareil de dissipation thermique (10) selon la revendication 1, dans lequel soit la pluralité de plaques nervurées (12) est formée en utilisant un processus de soufflage par laminage à chaud ; soit la pluralité de plaques nervurées (12) est formée par un procédé d'emboutissage et de brasage.

3. Appareil de dissipation thermique (10) selon la revendication 1, dans lequel un bossage (113) est disposé sur une surface extérieure de la quatrième plaque latérale (111), et une première interface (1110) est située sur un dessus du bossage (113).

4. Appareil de dissipation thermique (10) selon la revendication 1, dans lequel une partie de la seconde interface (123) qui est reliée à la première interface (1110) a la forme d'une bouche de corne.

5. Appareil de dissipation thermique (10) selon la revendication 1, dans lequel la pluralité des plaques nervurées (12) et la quatrième plaque latérale (111) sont perpendiculaires l'une à l'autre.

6. Appareil de dissipation thermique (10) selon l'une quelconque des revendications 1 à 5, dans lequel la pluralité de plaques nervurées (12) sont disposées parallèlement les unes aux autres ou disposées dans un angle inclus, dans lequel l'angle inclus est défini entre la quatrième plaque latérale (111) de l'évaporateur (11) et chacune des plaques nervurées (12), dans lequel l'angle inclus est compris entre 0 et 90 degrés.

7. Appareil de dissipation thermique (10) selon l'une quelconque des revendications 1 à 6, dans lequel la pluralité de plaques nervurées (12) est rectangulaire, en forme de L inversé ou en forme de Z inversé.

8. Station de base de communication sans fil, comprenant : un boîtier (20), des sources de chaleur (30), et l'appareil de dissipation thermique (10) selon l'une quelconque des revendications 1 à 7, dans lequel une ouverture de montage (21) pour le montage de l'appareil de dissipation thermique (10) est prévue sur le boîtier (20), les sources de chaleur (30) sont disposées dans le boîtier (20), et au moins une partie des sources de chaleur (30) sont thermiquement reliées à l'évaporateur (11).
